# EUROPÄISCHE PATENTSCHRIFT

(11) **EP 3 204 762 B1**
(45) Veröffentlichungstag und Bekanntmachung des Hinweises auf die Patenterteilung: **21.11.2018**
(21) Anmeldenummer: 16793776.2
(22) Anmeldetag: 21.10.2016
(51) Int. Cl.: G01N 27/61, G01N 27/92, G01R 31/16

(54) **VERFAHREN UND VORRICHTUNG ZUR PRÜFUNG VON PRÜFOBJEKTEN AUF DAS VORLIEGEN VON BESCHÄDIGUNGEN**
METHOD AND DEVICE FOR TESTING TEST OBJECTS FOR THE PRESENCE OF DAMAGE
PROCÉDÉ ET DISPOSITIF POUR INSPECTER DES OBJETS AFIN DE RECHERCHER LA PRÉSENCE DE DÉTÉRIORATIONS

(30) Priorität: 27.10.2015 DE 102015118287
(43) Veröffentlichungstag der Anmeldung: 16.08.2017
(73) Patentinhaber: INTRAVIS Gesellschaft für Lieferungen und Leistungen von bildgebenden und bildverarbeitenden Anlagen und Verfahren mbH, 52068 Aachen (DE)
(72) Erfinder: SCHÖNHOFF, Klaus, 52146 Würselen (DE); ZIRNIG, Holger, 40880 Ratingen (DE); KOZIESSA, Olaf, 52511 Geilenkirchen (DE); FUHRMANN, Gerd, 52066 Aachen (DE)
(74) Vertreter: Kohlmann, Kai
(86) Internationale Anmeldenummer: PCT/EP2016/075390
(87) Internationale Veröffentlichungsnummer: WO 2017/072044

(56) Entgegenhaltungen:
- EP-A1- 1 965 207
- EP-A2- 0 377 208
- DE-A1- 3 915 797
- DE-A1-102013 014 473
- US-A- 4 155 093
- US-A- 6 009 744

## Beschreibung

Die Erfindung betrifft ein Verfahren und eine Vorrichtung zur Prüfung von übereinstimmenden Prüfobjekten auf das Vorliegen von Löchern oder Rissen in einer Bodenfläche, wobei jedes Prüfobjekt von der Bodenfläche, einer der Bodenfläche gegenüberliegenden Öffnung und einer sich zwischen der Öffnung und der Bodenfläche erstreckenden Mantelfläche begrenzt wird.

Typische Prüfobjekte sind beispielsweise Kunststoff-Verschlusskappen die dazu dienen, Behälter luftdicht zu verschließen. Derartige Verschlusskappen können im Bereich des Öffnungsrandes ein Garantieband, das sogenannte Frischesiegel, aufweisen, welches sich beim Öffnen von der Verschlusskappe ablöst. Um dieses Ablösen zu erleichtern, ist das Garantieband nur über dünne Stege mit der Verschlusskappe verbunden. Das Garantieband kann unmittelbar beim Spritzgießprozess der Verschlusskappe hergestellt werden. Eine andere Möglichkeit besteht darin, in geringem Abstand zum Öffnungsrand gleichmäßig über den Umfang verteilt Schlitze in die Verschlusskappe einzubringen. Ferner sind Verschlusskappen bekannt, an deren Öffnungsrand mehrere Klappen über Stege befestigt sind, die an der Innenseite der Verschlusskappe beim Aufschrauben zur Anlage bringbar sind. Derartige Verschlusskappen weisen herstellungsbedingt zwischen dem Garantieband beziehungsweise den Klappen und der Mantelfläche Öffnungen auf.

Die Kunststoff-Verschlusskappen werden üblicherweise als Spritzgussteile hergestellt. Bei der Herstellung können in der Nähe des Anspritzpunktes Undichtigkeiten in der Bodenfläche auftreten, sogenannte Mikrolöcher oder Mikrorisse. In der Verschlusskappe eines Behälters müssen Löcher und Risse jedoch vermieden werden, um einen unerwünschten Austritt des Inhalts aus dem mit der Verschlusskappe verschlossenen Behälter oder einen unerwünschten Eintritt von Gasen oder Flüssigkeiten in den Behälter zu vermeiden.

Es besteht daher ein Bedürfnis, Prüfobjekte, insbesondere Kunststoff-Verschlusskappen mit derartigen Fehlern automatisch zu erkennen und auszusortieren.

Die JP S64-046 622 A offenbart ein Verfahren zur Prüfung von Behältern auf Dichtigkeit, bei dem die Behälter kontinuierlich mittels einer Fördereinrichtung in einer Transportebene transportiert werden, wobei mittels einer Hochspannungsquelle eine Prüfspannung zwischen einer oberhalb der Transportebene ortsfest angeordneten Konzentrationselektrode und einer in der Transportebene ortsfest angeordneten seitlichen Elektrode angelegt wird, wenn sich der zu prüfende Behälter zwischen den Elektroden befindet. Eine Leckage in dem Behälter wird erkannt, falls ein Durchschlag zwischen den Elektroden aufgrund des sich ändernden Füllstandes in dem Behälter von einem Stromstärkemessgerät erkannt wird.

Die DE 32 13 100 A1 offenbart ein Verfahren zum Ermitteln und Ausscheiden von fehlerhaften keramischen Gegenständen, bei dem die Fehler durch elektrostatische Aufladung festgestellt werden. Die keramischen Gegenstände werden kontinuierlich durch eine Prüfstation bewegt, in der sie aufeinanderfolgenden Hochspannungsentladungen ausgesetzt werden, sodass im Wesentlichen sämtliche Bereiche der keramischen Gegenstände von den Hochspannungsentladungen erfasst werden. Die Elektroden sind unterhalb der Bewegungsbahn der zu prüfenden keramischen Gegenstände angeordnet und entsprechen in ihrer Form der Form der keramischen Gegenstände. Entlang der Bewegungsbahn sind Fühler vorgesehen, die die zu prüfenden keramischen Gegenstände erfassen und die aufeinanderfolgenden Entladungen der Elektroden entsprechend einem vorherbestimmten Programm steuern. Die Gegenstände lassen sich dadurch während der Bewegung vollständig überprüfen und Fehler der Teile machen sich in einem Ladungsbild bemerkbar, dass von Empfängerelektroden erfasst wird. Fehlersignale aktivieren eine Ausscheidungseinrichtung, die das als fehlerhaft erkannte Teil von der Transporteinrichtung entfernt.

Aus der DE 31 36 538 C2 ist eine Elektrodenanordnung umfassend zwei Elektroden zur Prüfung von Prüfobjekten auf das Vorliegen von Löchern oder Rissen bekannt, wobei die beiden Elektroden gegensätzlich zueinander polarisiert sind. Eine der beiden Elektroden steht in Kontakt mit dem zu prüfenden Prüfobjekt und die andere Elektrode ist teilweise an die Außenkontur des Prüfobjektes angepasst, das mit Hilfe eines Förderers entlang einer Transportstrecke an den Elektroden vorbeibewegt wird. Die an den Elektroden anliegende Spannung erzeugt einen Korona-Entladestrom zwischen den Elektroden, wenn das Prüfobjekt keine Undichtheit aufweist und einen Funken-Entladestrom zwischen den Elektroden, wenn das Prüfobjekt eine Undichtigkeit, d.h. ein Mikroloch oder Riss aufweist.

Aus der DE 10 2013 014 473 A1 ist darüber hinaus eine Vorrichtung zum Überprüfen von Kunststoff-Verschlusskappen auf das Vorliegen von Mikrolöchern oder Mikrorissen bekannt geworden, bei der eine Elektrode als Finger eines Sternrades ausgeführt ist, der in die Verschlusskappe bis auf den Boden eintaucht. Eine Gegenelektrode ist feststehend auf der anderen Seite des Bodens unterhalb einer Transporteinrichtung für die Verschlusskappen angebracht, die parallel angeordnete, gleichlaufende Transportbänder aufweist. Die Verschlusskappen dürfen beim Durchlaufen durch die Prüfeinrichtung nicht durch das Sternrad beschädigt werden. Eine typische Beschädigungsgefahr besteht darin, dass der eintauchende Finger nicht in die Verschlusskappe eintaucht, sondern auf den Öffnungsrand auftrifft. Um derartige Beschädigungen zu vermeiden, werden die Verschlusskappen üblicherweise lückenlos aneinander liegend, gestaut unter dem Sternrad hindurchgeführt, sodass ein Finger nach dem anderen in die aneinander liegenden Verschlusskappen störungsfrei eingreifen kann. Die Aufstauung der Verschlusskappen wird dadurch erreicht, dass sich die Verschlusskappen im Staubereich vor dem Sternrad langsamer als die Transporteinrichtung bewegen. Dies kann beispielsweise durch Regelung der Drehgeschwindigkeit des Sternrades relativ zur Vorschubgeschwindigkeit der Transportbänder erreicht werden.

Die zur beschädigungsfreien Prüfung der Verschlusskappen erforderliche Stauung hat jedoch mehrere Nachteile:
- Aufgrund der Relativgeschwindigkeit zwischen den Transportbändern der Transporteinheit und den Verschlusskappen tritt Reibung auf, die zur Beschädigung der Verschlusskappen führen kann, beispielsweise eines auf der Oberseite der Verschlusskappe aufgebrachten Druckbildes.
- Der Stau der Verschlusskappen muss eine bestimmte Mindestlänge aufweisen, damit unter keinen Umständen eine Lücke unter dem Stachelrad auftritt. Die Mindestlänge erfordert eine bestimmte Baugröße der Prüfeinrichtung, die bei deren Integration in die Herstellungsanlage nachteilig sein kann.
- Sofern Verschlusskappen mit einem Garantieband oder Klappen geprüft werden sollen, ist der Prüfeinrichtung vielfach ein sogenannter Slitter zur Herstellung des Garantiebandes oder ein Folder zur Herstellung der Klappen vorgeschaltet. Aus Kosten- und Platzgründen weisen die Prüfeinrichtung und der vorgeschaltete Slitter oder Folder vorzugsweise eine gemeinsame Transporteinrichtung für die Verschlusskappen auf. Der für die Prüfeinrichtung erforderliche Rückstau der Verschlusskappen darf sich jedoch auf keinen Fall bis in den vorgeschalteten Slitter oder Folder erstrecken, da diese Vorrichtungen hierdurch Schaden nehmen können.

Ausgehend von diesem Stand der Technik liegt der Erfindung die Aufgabe zugrunde, ein Verfahren zur Prüfung von übereinstimmenden Prüfobjekten auf das Vorliegen von Löchern oder Rissen zu schaffen, das ohne Rückstau und Reibung zwischen den Prüfobjekten und der Transporteinrichtung arbeitet. Außerdem soll eine Vorrichtung zur Durchführung des Verfahrens angegeben werden.

Die Lösung dieser Aufgabe basiert auf dem Gedanken, dass die Elektroden nicht mechanisch mit den Prüfobjekten in Berührung gelangen und die Lage der Prüfobjekte auf der Transporteinrichtung nicht verändert wird.
Im Einzelnen wird die Aufgabe durch ein Verfahren mit den Merkmalen des Anspruchs 1 und eine Vorrichtung mit den Merkmalen des Anspruchs 18 gelöst.

Es wird eine Elektrodenanordnung bereitgestellt, die eine oberhalb einer Transportebene ortsfest angeordnete obere Elektrode und eine unterhalb der Transportebene ortsfest angeordnete untere Elektrode sowie eine Entladungsstrecke zwischen der oberen und unteren Elektrode aufweist. Die Prüfobjekte werden entlang einer in der Transportebene liegenden Transportstrecke zwischen der oberen und der unteren Elektrode transportiert, ohne die Elektroden zu berühren. Der Transport der Prüfobjekte in der Transportebne erfolgt insbesondere mit einer Transporteinrichtung umfassend zwei parallele, gleichlaufende Transportbänder, wie sie beispielsweise aus der DE 10 2013 014 473 A1 bekannt ist.

Um Mikrolöcher und Risse in den Prüfobjekten feststellen zu können, wird die Höhe der Prüfspannung derart gesteuert, dass diese größer oder gleich der Durchschlagsspannung zwischen den Elektroden in Luft, jedoch kleiner als die Durchschlagsspannung durch ein einwandfreies Prüfobjekt ohne Löcher oder Risse zwischen den Elektroden ist. Dabei wird unter Durchschlagsspannung diejenige Spannung verstanden, welche notwendig ist, um Strom durch einen Isolator fließen zu lassen.

Aufgrund des berührungslosen, ungestauten Transportes entstehen Lücken zwischen den Prüfobjekten auf der Transportstrecke. Um Durchschläge zwischen den Elektroden in diesen Lücken zu verhindern, wird die Prüfspannung zwischen den Elektroden zeitlich und synchron zur Bewegung der Prüfobjekte derart gesteuert, dass die Prüfspannung zwischen den Elektroden nur dann anliegt, wenn sich eines der Prüfobjekte zwischen der oberen und unteren Elektrode befindet. Eine übliche Prüfspannung zwischen den Elektroden liegt in der Größenordnung von etwa 30 kV. Um derart hohe Prüfspannungen betriebssicher zu steuern, wird die Prüfspannung von einer ersten, gesteuerten Spannungsquelle und einer zweiten Spannungsquelle erzeugt, wobei die beiden Spannungsquellen elektrisch in Reihe geschaltet sind. Die Summe der von beiden Spannungsquellen erzeugten Spannungen liegt als Prüfspannung an den Elektroden an.

Die Spannung von der ersten, gesteuerten Spannungsquelle wird nur dann erzeugt, wenn sich eines der Prüfobjekte zwischen den Elektroden befindet, während die Spannung von der zweiten Spannungsquelle kontinuierlich während der Prüfung erzeugt wird. Die Höhe der kontinuierlich erzeugten Spannung ist vorzugsweise knapp unterhalb der Durchschlagsspannung zwischen den Elektroden in Luft. Die Höhe der von der ersten gesteuerten Spannungsquelle erzeugten Spannung, die zur Erzielung der Prüfspannung erforderlich ist, ist daher vergleichsweise gering, sodass die Belastung der Schaltelemente zum Ein- und Ausschalten der ersten, steuerbaren Spannungsquelle erheblich reduziert wird.

Hierdurch wird unter Berücksichtigung der Vielzahl der Steuerungsvorgänge über die Nutzungsdauer eine deutlich verbesserte Zuverlässigkeit der Vorrichtung zur Durchführung des erfindungsgemäßen Prüfverfahrens erreicht.

Das Feststellen ob ein Loch oder Riss in dem Prüfobjekt vorliegt, erfolgt durch Erkennen eines Durchschlages auf der Entladungsstrecke zwischen den Elektroden. Liegt ein Loch oder Riss in der Bodenfläche des Objektes vor, entfällt im Bereich des Lochs beziehungsweise Risses die Isolationsbewirkung des Prüfobjektes. Da die Prüfspannung größer oder gleich der Durchschlagsspannung zwischen den Elektroden in Luft ist, kommt es zu einem Durchschlag auf der Entladungsstrecke zwischen den Elektroden, der sich als Stromfluss zwischen den Elektroden äußert.

Um den berührungslosen Transport der Prüfobjekte entlang der Transportstrecke zu gewährleisten, wird der Abstand zwischen der oberen und unteren Elektrode in Abhängigkeit der größten Erstreckung der jeweils zu prüfenden Prüfobjekte senkrecht zu der Transportebene eingestellt. Die Transportebene wird durch die tragende Oberfläche der Transporteinrichtung, insbesondere die vorzugsweise parallelen, gleichlaufenden Transportbänder definiert. Verschlusskappen werden üblicherweise mit der Öffnung nach oben transportiert, sodass die Höhe der Verschlusskappen der größten Erstreckung senkrecht zu der Transportebene entspricht. Üblicherweise liegt die Höhe der Verschlusskappen zwischen 8 mm und 20 mm. Der Abstand zwischen der unteren und oberen Elektrode sollte lediglich geringfügig, d.h. maximal 2 mm größer als die Höhe der Verschlusskappen gewählt werden, um unnötig hohe Prüfspannungen zu vermeiden.

Für die Steuerung der Prüfspannung zwischen den Elektroden ist es vorteilhaft, wenn die erste Spannungsquelle eine zeitlich veränderliche Spannung erzeugt. Die Spannungsquelle kann als Wechselspannungsquelle ausgestaltet sein, die eine sich zeitlich periodisch veränderliche Spannung erzeugt. In Betracht kommt beispielsweise eine Wechselspannungsquelle mit 100 kHz. Die Spannungsquelle kann jedoch auch derart gesteuert werden, dass lediglich ein oder mehrere Spannungsimpuls(e) von der ersten Spannungsquelle erzeugt werden, wenn sich eines der Prüfobjekte zwischen den Elektroden befindet.

Besonders vorteilhaft ist es, wenn die erste Spannungsquelle zur Erzeugung einer zeitlich veränderlichen Spannung einen Transformator mit einer Sekundärseite und einer Primärseite umfasst, wobei die Steuerung der ersten Spannungsquelle über die Primärseite erfolgt. Die Steuerung kann primärseitig mit der im industriellen Umfeld üblichen Versorgungsspannung von 24 Volt erfolgen, sodass die zahlreichen Schaltvorgänge die Spannungsquelle kaum belasten. Hierdurch wird eine hohe Zuverlässigkeit der Prüfvorrichtung erreicht. Hinzu kommt eine geringe Leistungsaufnahme, weil die Prüfspannung pro Prüfobjekt lediglich für eine kurze Dauer bereitgestellt wird.

Für eine zuverlässige Erkennung eines Durchschlages zwischen den beiden Elektroden ist es vorteilhaft, wenn die zweite Spannungsquelle eine Gleichspannung erzeugt und die Durchschlagserkennung an der zweiten Spannungsquelle erfolgt.

Um den Aufwand für die Steuerung der ersten Spannungsquelle zu reduzieren, werden die erste und zweite Spannungsquelle vorzugsweise durch Anschluss an einen gemeinsamen Massepunkt elektrisch in Reihe geschaltet.

Sofern die Prüfobjekte herstellungsbedingte Öffnungen aufweisen, wie beispielsweise Kunststoff-Verschlusskappen mit Garantieband oder Klappen, muss verhindert werden, dass ein Durchschlag auf einer nicht vorgesehenen Entladungsstrecke durch diese Öffnungen auftritt. In einem solchen Fall würde die Verschlusskappe als fehlerhaft erkannt und aussortiert. Das Ausleiten möglicherweise fehlerfreier Verschlusskappen ist jedoch aus wirtschaftlichen Gründen unerwünscht.

Um Durchschläge auf einer nicht vorgesehenen Entladungsstrecke zu vermeiden, wird vorzugsweise eine Elektrodenanordnung umfassend miteinander fluchtende, stabförmige Elektroden bereitgestellt. Die erste Spannungsquelle wird bei der Prüfung von Prüfobjekten mit einer einen Mittelpunkt aufweisenden Bodenfläche derart gesteuert, dass eine Spannung von der ersten Spannungsquelle erst dann erzeugt wird, wenn sich der Mittelpunkt in der Flucht oder einem festgelegten, vorzugsweise konzentrischen Bereich um die Flucht herum befindet, wobei der Bereich deutlich kleiner als die Bodenfläche ist. Hierdurch befinden sich etwaige, herstellungsbedingte Öffnungen zwischen dem Öffnungsrand der Verschlusskappe und dem Garantieband bzw. den Klappen möglichst weit entfernt von den stabförmigen Elektroden, wodurch Durchschläge auf einer nicht vorgesehenen Entladungsstrecke weitgehend vermieden werden.

Weitere Maßnahmen zur Verhinderung eines Durchschlages entlang einer nicht vorgesehenen Entladungsstrecke bestehen darin, dass der Verlauf der vorgesehenen Entladungsstrecke durch gezielte Ionisierung der Luft und/oder durch ein magnetisches Feld und/oder elektrisches Feld beeinflusst wird:
- Die gezielte, räumlich begrenzte Ionisierung der Luft entlang der vorgesehenen Entladungsstrecke auf dem kürzesten Weg zwischen den Elektroden kann beispielsweise mit Hilfe gebündelter und räumlich konzentrierter optischer Strahlung, bevorzugt im ultravioletten Bereich erreicht werden. Ferner kann eine gezielte Ionisierung der Luft mit Hilfe von geschalteten Lasern oder radioaktiven Quellen erfolgen. Zusätzlich kann die Ausbreitung der Ionisierung durch eine gerichtete Luftströmung beeinflusst werden.
- Magnetische Felder lassen sich sowohl durch Dauermagnete als auch Elektromagnete erzeugen, deren Feldlinien parallel zur vorgesehenen Entladungsstrecke verlaufen.
- Schließlich kann der Verlauf der Entladungsstrecke durch elektrische Felder beeinflusst werden. Hierzu können sich die stabförmigen Elektroden auf ihrer, dem Prüfobjekt zugewandten Seiten, zu einer Spitze mit einem Radius von insbesondere unter 1 mm verjüngen.

Für die positionsabhängige Steuerung der ersten Spannungsquelle wird die Position des Prüfobjektes auf der Transportstrecke zwischen der oberen und unteren Elektrode vorzugsweise mithilfe mindestens eines Sensors erfasst. Als Sensoren kommen beispielsweise Lichtschranken, Lichttaster oder auch andere, beispielsweise taktile Sensoren in Betracht.

Um abhängig von dem Prüfergebnis der Prüfobjekte den Ausschuss bei der Herstellung der Prüfobjekte zu reduzieren, ist in einer Ausgestaltung des erfindungsgemäßen Verfahrens vorgesehen, dass die Prüfobjekte während des Transportes entlang der Transportstrecke zusätzlich eine optische Prüfeinrichtung durchlaufen, die zum Lesen von in die Prüfobjekte eingegossenen Informationen eingerichtet ist. Bei spritzgegossenen Verschlusskappen kann es sich bei dieser Information beispielsweise um eine Kavitätennummer handeln, die einen Rückschluss auf das Formnest des Spritzgießwerkzeuges erlaubt, aus dem das fehlerhafte Prüfobjekt stammt. Da die Prüfung der Prüfobjekte auf Mikrolöcher oder Mikrorisse auf derselben Transportstrecke erfolgt, auf der auch die optische Prüfung stattfindet, kann das Prüfergebnis auf das Vorliegen von Mikrolöchern beziehungsweise Mikrorissen in den Verschlusskappen mit der Kavitätennummer korreliert werden und damit eine formnestbezogene Auswertung der Fehlerhäufigkeit durchgeführt werden. Hierdurch können frühzeitig geeignete Maßnahmen in der Herstellung der Verschlusskappen eingeleitet werden, um die Fehlerhäufigkeit zu reduzieren. Beispielsweise kann bei Feststellung einer Häufung von fehlerhaften Verschlusskappen aus einem bestimmten Formnest durch Rückkopplung der Prüfergebnisse gezielt ein Formnest abgeschaltet und damit die Herstellung von Ausschuss reduziert werden.

Nachfolgend wird die Erfindung anhand der Figuren näher erläutert. Es zeigen
- **Figur 1**: eine schematische Darstellung einer Elektrodenanordnung sowie einer Transporteinrichtung einer Vorrichtung zur Durchführung des erfindungsgemäßen Verfahrens,
- **Figur 2**: eine Schematische Darstellung einer ersten und zweiten Spannungsquelle zur Erzeugung einer Prüfspannung in einer Vorrichtung zur Durchführung des erfindungsgemäßen Verfahrens,
- **Figur 3**: eine schematische Darstellung von unterschiedlichen Verschlusskappen mit Garantieband beziehungsweise Klappen am oberen Öffnungsrand,

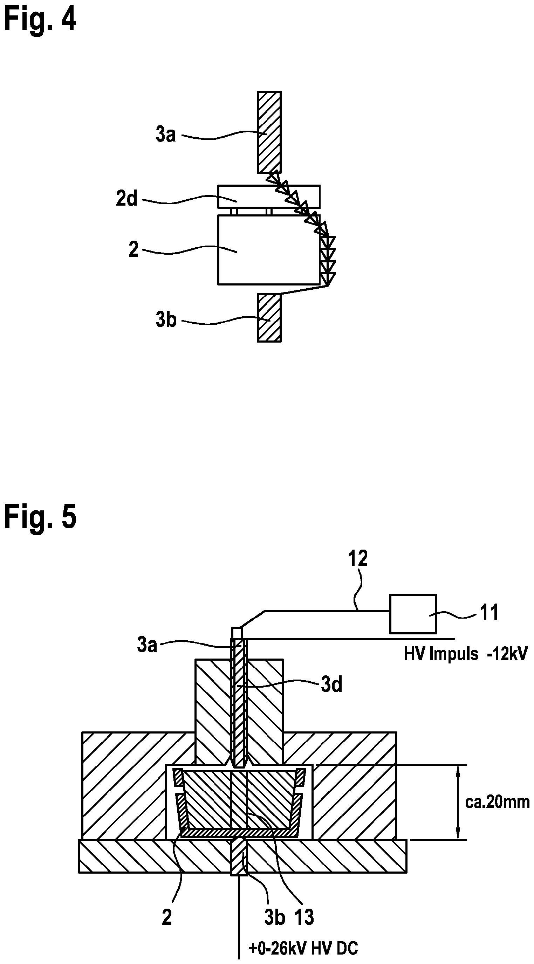

- **Figur 4**: eine schematische Darstellung eines Durchschlages entlang einer nicht vorgesehenen Entladungsstrecke sowie
- **Figur 5**: eine schematische Darstellung einer Elektrodenanordnung mit einer Ionisierungseinrichtung zur Beeinflussung der Entladungsstrecke.

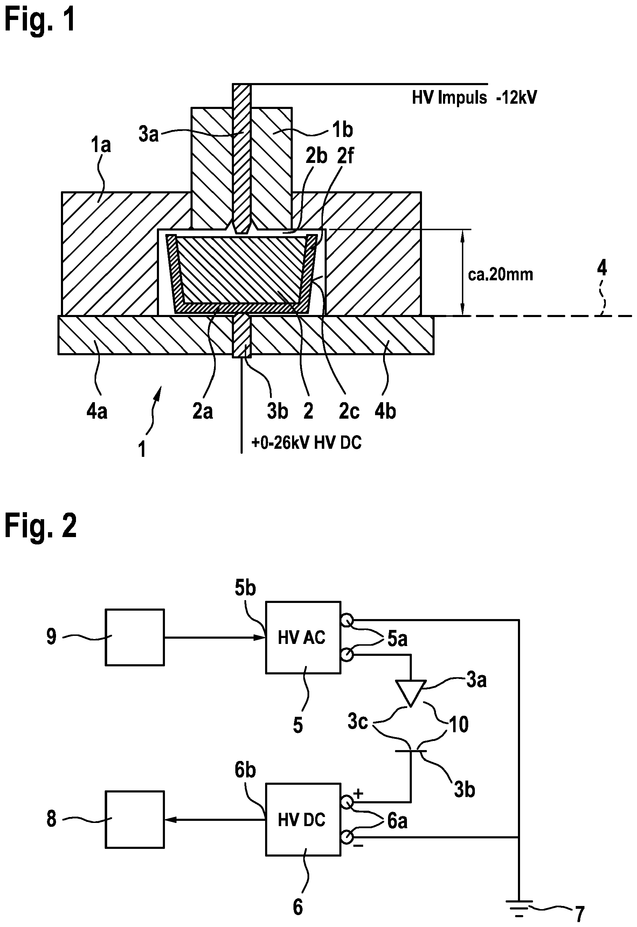

Figur 1 zeigt schematisch einen Teil einer Vorrichtung (1) zur Prüfung von übereinstimmenden Prüfobjekten (2) auf das Vorliegen von Löchern oder Rissen in einer Bodenfläche (2a), wobei jedes Prüfobjekt (2) von der Bodenfläche (2a), einer der Bodenfläche (2a) gegenüberliegenden Öffnung (2b) und einer sich zwischen der Öffnung (2b) und der Bodenfläche (2a) erstreckenden Mantelfläche (2c) begrenzt wird. Bei den Prüfobjekten (2) handelt es sich insbesondere um spritzgegossene Kunststoff-Verschlusskappen zum Verschließen von Behältern.

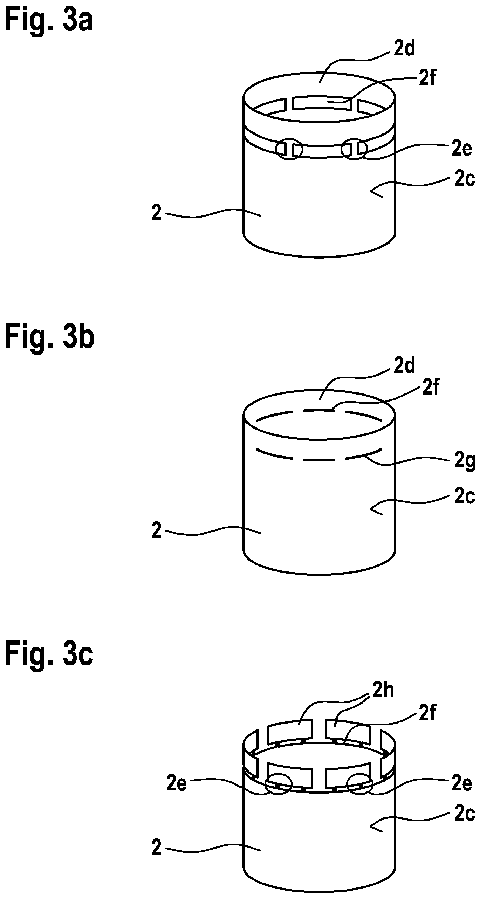

Figuren 3a, 3b zeigen Verschlusskappen (2) mit einem Garantieband (2d). Das Garantieband (2d) ist bei der Verschlusskappe (2) nach Figur 3a mit schmalen Stegen (2e) an dem die Öffnung (2b) begrenzenden Rand (2f) befestigt. Bei der Verschlusskappe (2) nach Figur 3b trennen Schlitze (2g) entlang des Umfangs des Randes (2f) das Garantieband (2d) von der Mantelfläche (2c).

Die Verschlusskappe nach Figur 3c weist entlang des Randes (2f) an der Öffnung (2b) mehrere Klappen (2h) auf, die mit dem Rand (2f) entlang der Öffnung (2b) über Stege (2e) elastisch verbunden sind.

Das Garantieband (2d) soll sich beim Öffnen von der Verschlusskappe lösen. Die Klappen bewegen sich beim Öffnen der Verschlusskappe von der Innenseite der Verschlusskappe nach außen.

Eine Elektrodenanordnung (3) der Vorrichtung (1) umfasst eine oberhalb einer Transportebene (4) ortsfest angeordnete obere, stabförmige Elektrode (3a) und eine unterhalb der Transportebene (4) ortsfest angeordnete untere, stabförmige Elektrode (3b) sowie eine Entladungsstrecke (3c). Zwischen der oberen Elektrode (3a) und der unteren Elektrode (3b) liegt zeitweilig eine Prüfspannung (10) an, die von einer ersten und einer zweiten Spannungsquelle (5,6) erzeugt wird.

Die erste, gesteuerte Spannungsquelle (5) ist in dem in Figur 2 dargestellten Ausführungsbeispiel eine Wechselspannungsquelle, die eine zeitlich veränderliche Spannung mit einer Amplitude von 12 kV an den Klemmen (5a) erzeugt. Die Wechselspannungsquelle umfasst einen nicht dargestellten Transformator an dessen Primärseite zeitweilig eine von einer Steuerung (9) geschaltete Eingangswechselspannung in Höhe von 24 Volt anliegt, die der Transformator aufgrund seines Übersetzungsverhältnisses auf die Klemmenspannung transformiert.

Die zweite Spannungsquelle (6) ist in dem in Figur 2 dargestellten Ausführungsbeispiel eine Gleichspannungsquelle, die an den Klemmen (6a) eine Gleichspannung von 26 kV erzeugt. Die Gleichspannungsquelle umfasst ebenfalls einen Transformator, der die Eingangswechselspannung in die gleichgerichtete Klemmenspannung von 26 kV umwandelt.

Wie aus Figur 2 weiter erkennbar, sind die Gleichspannungsquelle (6) und die Wechselspannungsquelle (5) jeweils über eine ihrer beiden Klemmen (5a, 6a) über einen gemeinsamen Massepunkt (7) miteinander verbunden. Die Elektroden (3a,3b) sind mit den jeweils anderen Klemmen (5a, 6a) der Wechselspannungsquelle (5) beziehungsweise Gleichspannungsquelle (6) verbunden. Über die Entladungsstrecke (3c) ergibt sich durch diese Schaltungsanordnung eine Reihenschaltung der Gleichspannungsquelle (6) mit der Wechselspannungsquelle (5).

Die Gleichspannungsquelle (6) ist über einen Ausgang (6b) mit einer Auswerteeinrichtung (8) zum Erkennen eines Durchschlages auf der Entladungsstrecke (3c) zwischen den Elektroden (3a,3b) verbunden.

Die Wechselspannungsquelle (5) verfügt über einen Steuereingang (5b), der mit der Steuerung (9) verbunden ist. Die Steuerung (9) schaltet die Wechselspannungsquelle (5) über den Steuereingang (5b) derart, dass an den Klemmen (5a) nur dann eine Wechselspannung erzeugt wird, wenn sich eines der Prüfobjekte (2) zwischen der oberen Elektrode (3a) und der unteren Elektrode (3b) befindet, wie dies schematisch in Figur 1 angedeutet ist. Gleichzeitig bewirkt die Steuerung (9), dass die Spannung von der Gleichspannungsquelle (6) kontinuierlich während der Prüfung von Prüfobjekten (2) an den Klemmen (6a) anliegt, wobei die Summe der von der Wechselspannungsquelle (5) und Gleichspannungsquelle (6) erzeugten Spannung aufgrund der Reihenschaltung als Prüfspannung (10) zwischen den Elektroden (3a,3b) anliegt.

Ferner steuert die Steuerung (9) die Gleichspannungsquelle (6) und die Wechselspannungsquelle (5) derart, dass die Höhe der Prüfspannung (10) größer als die Durchschlagspannung zwischen den Elektroden (3a,3b) in Luft, d.h. in Abwesenheit eines Prüfobjektes (2) zwischen den Elektroden (3a, 3b) ist. Zugleich begrenzt die Steuerung (9) die Prüfspannung (10) auf einen Wert, der kleiner als die Durchschlagsspannung zwischen den Elektroden (3a, 3b) durch ein einwandfreies Prüfobjekt (2) ohne Löcher oder Risse in der Bodenfläche (2a) ist.

Durch diese Steuerung der Prüfspannung wird gewährleistet, dass es nur dann zu einem Durchschlag auf der Entladungsstrecke (3c) kommt, wenn das Prüfobjekt (2) ein Loch oder Riss in der Bodenfläche (2a) aufweist. In diesem Fall erstreckt sich die Entladungsstrecke (3c) zwischen der oberen Elektrode (3a) durch das Loch oder den Riss hindurch bis zur unteren Elektrode (3b). Da die Prüfspannung größer als die Durchschlagsspannung in Luft ist, kommt es zu einem Durchschlag, d.h. es fließt ein elektrischer Strom über die Entladungsstrecke (3c).

Um die Prüfobjekte (2) entlang einer in der Transportebene (4) liegenden und senkrecht zur Bildebene in Figur 1 verlaufenden Transportstrecke zu transportieren, weist die Vorrichtung (1) vorzugsweise zwei parallele, in gleicher Richtung laufende Transportbänder (4a,4b) auf. Die beiden Transportbänder (4a,4b) sind im Abstand zueinander angeordnet, sodass sich die untere Elektrode (3b) bis an die Oberfläche der Transportebene (4), die von der Oberfläche der Transportbänder (4a,4b) im Obertrum gebildet wird, heran erstreckt.

An einem Halterahmen (1a) der Vorrichtung (1) ist eine Halterung (1b) höhenverstellbar angeordnet, die die obere Elektrode (3a) fluchtend zu der unteren Elektrode (3b) aufnimmt. Die Halterung (1b) besteht aus einem isolierenden Material, in das die Elektrode eingebettet ist. Mit Hilfe der höhenverstellbaren Halterung (1b) für die obere Elektrode (3a) lässt sich der Abstand zwischen der oberen und unteren Elektrode (3a, 3b) in Abhängigkeit von der größten Erstreckung der zu prüfenden Prüfobjekte (2) - hier der Höhe der Verschlusskappen - senkrecht zur der Transportebene (4) einstellen. Dabei wird der Abstand so klein wie möglich eingestellt, sodass die obere Elektrode (3a) gerade nicht mit dem oberen Rand (2f) des Prüfobjektes (2) kollidiert. Der Abstand der oberen Elektrode zu dem Rand (2f) des Prüfobjektes sollte in vertikaler Richtung zur Transportebene (4) maximal 2 mm betragen.

In dem dargestellten Ausführungsbeispiel weisen die Verschlusskappen eine kreiszylindrische Bodenfläche mit einem Mittelpunkt auf. Bei derartigen Prüfobjekten (2) wird die Wechselspannungsquelle (5) von der Steuerung (9) derart angesteuert, dass an den Klemmen (5a) erst dann eine Spannung anliegt, wenn sich der Mittelpunkt in der Flucht der beiden Elektroden (3a,3b) oder in einem festgelegten, kleinen konzentrischen Bereich um die Flucht herum befindet. Durch die Zentrierung der Prüfobjekte (2) gegenüber den Elektroden (3a,3b) kann ein Durchschlag entlang einer nicht vorgesehenen Entladungsstrecke vermieden werden. Die nicht zu prüfenden Öffnungen zwischen dem Garantieband (2d) beziehungsweise den Klappen (2b) einer Verschlusskappe befinden sich durch eine Zentrierung in einem größtmöglichen Abstand zwischen den Elektrodenspitzen, sodass bei entsprechender Höheneinstellung der oberen Elektrode (3a) Durchschläge nahezu ausschließlich über etwaige, zu detektierende Mikrolöcher bzw. Mikrorisse erfolgen, zumal sich diese zumeist im Bereich des Anspritzpunktes, d.h. am Mittelpunkt der Bodenfläche befinden.

Zur Vermeidung eines Durchschlages entlang einer nicht vorgesehenen Entladungsstrecke bei einer Verschlusskappe entsprechend Figuren 3a- 3c besteht zusätzlich die Möglichkeit, dass die Vorrichtung eine zur Ionisierung der Luft entlang der Entladungsstrecke (3c) geeignete Strahlungsquelle (11) aufweist, wobei die von der Strahlungsquelle (11) erzeugte UV-Strahlung über einen Wellenleiter (12) in eine zentrische, die obere Elektrode (3a) durchsetzende Bohrung (3d) eingekoppelt wird, aus der die Strahlung an deren Unterseite in Richtung der unteren Elektrode (3b) austritt. Die Strahlung erzeugt einen ionisierten Bereich (13) zwischen den Elektroden (3a, 3b).

Um die Position der Prüfobjekte (2) auf der Transportstrecke zwischen den Elektroden (3a,3b) zu erfassen, ist die Steuerung (9) mit mindestens einem in der Zeichnung nicht dargestellten Sensor, beispielsweise einer Lichtschranke, verbunden.

Erfassen die Sensoren, dass sich eines der Prüfobjekte zentrisch zwischen den Elektroden (3a,3b) wie in Figur 1 dargestellt befindet, erzeugt die Wechselspannungsquelle (5) für den Zeitraum der Prüfung an den Klemmen (5a) die Wechselspannung, die sich mit der Gleichspannung an den Klemmen (6a) der Gleichspannungsquelle (6) zu der Prüfspannung (10) summiert. Während des Transports der Prüfobjekte (2) entlang der Transportstrecke ist dabei lediglich eine geringe Abweichung der Lage der Prüfobjekte quer zum Verlauf der Transportstrecke zulässig. Andernfalls ist mit Hilfe der Sensoren eine zentrische Ausrichtung der Prüfobjekte (2) zu der oberen und unteren Elektrode (3a, 3b) nicht möglich. Als Anhaltspunkt kann eine Lagetoleranz von maximal +/- 2 mm, vorzugsweise +/- 1 mm quer zur Transportstrecke toleriert werden. Die Einhaltung der Lagetoleranz wird durch präzises Ablegen der Prüfobjekte auf dem Transportsystem sichergestellt.

Die Auswerteeinrichtung (8) erkennt einen Durchschlag auf der Entladungsstrecke (3c) zwischen der oberen und unteren Elektrode (3a, 3b) durch Auftreten eines Stromflusses in der Gleichspannungsquelle (6). Wird auf diese Weise ein fehlerhaftes Prüfobjekt erkannt, wird dieses automatisch aussortiert.

| **Nr.** | **Bezeichnung** |
|---|---|
| 1. | Vorrichtung |
| 1a. | Halterahmen |
| 1b. | Halterung |
| 2. | Prüfobjekt |
| 2a. | Bodenfläche |
| 2b. | Öffnung |
| 2c. | Mantelfläche |
| 2d. | Garantieband |
| 2e. | Stege |
| 2f. | Rand |
| 2g. | Schlitze |
| 2h. | Klappe |
| 3. | Elektrodenanordnung |
| 3a. | Obere Elektrode |
| 3b. | Untere Elektrode |
| 3c. | Entladungsstrecke |
| 3d. | Zentrische Bohrung |
| 4. | Transportebene |
| 4a,b. | Transportbänder |
| 5 . | Erste Spannungsquelle |
| 5a. | Klemmen |
| 5b. | Steuereingang |
| 6. | Zweite Spannungsquelle |
| 6a. | Klemmen |
| 6b. | Ausgang |
| 7. | Massepunkt |
| 8 . | Auswertung |
| 9. | Steuerung |
| 10. | Prüfspannung |
| 11. | UV-Strahlenquelle |
| 12. | Wellenleiter |
| 13. | Ionisierter Bereich |

## Patentansprüche

1. Verfahren zur Prüfung von übereinstimmenden Prüfobjekten (2) auf das Vorliegen von Löchern oder Rissen in einer Bodenfläche (2a), wobei jedes Prüfobjekt (2) von der Bodenfläche (2a), einer der Bodenfläche (2a) gegenüberliegenden Öffnung (2b) und einer sich zwischen der Öffnung (2b) und der Bodenfläche (2a) erstreckenden Mantelfläche (2c) begrenzt wird, mit den Schritten:
- Bereitstellen einer Elektrodenanordnung (3) umfassend eine oberhalb einer Transportebene (4) ortsfest angeordnete obere Elektrode (3a) und eine unterhalb der Transportebene (4) ortsfest angeordnete untere Elektrode (3b) sowie einer Entladungsstrecke (3c) zwischen der oberen und unteren Elektrode,
- Verbinden einer ersten, gesteuerten Spannungsquelle (5) mit einer der beiden Elektroden (3a) und Verbinden einer zweiten Spannungsquelle (6) mit der anderen der beiden Elektroden (3b), wobei die beiden Spannungsquellen (5, 6) elektrisch in Reihe geschaltet sind,
- Transportieren jedes Prüfobjektes (2) entlang einer in der Transportebene (4) liegenden Transportstrecke, die zwischen der oberen Elektrode (3a) und der unteren Elektrode (3b) verläuft,
- Steuern der ersten und zweiten Spannungsquelle (5, 6) derart, dass eine Spannung von der ersten Spannungsquelle (5) nur dann erzeugt wird, wenn sich eines der Prüfobjekte (2) zwischen der oberen und unteren Elektrode (3a, 3b) befindet, und dass eine Spannung von der zweiten Spannungsquelle (6) kontinuierlich während der Prüfung von Prüfobjekten (2) erzeugt wird, wobei die Summe der von beiden Spannungsquellen (5, 6) erzeugten Spannungen als Prüfspannung (10) an den Elektroden (3a, 3b) anliegt,
- Steuern der Höhe der Prüfspannung (10) derart, dass diese größer oder gleich der Durchschlagspannung zwischen den Elektroden (3a, 3b) in Luft und kleiner als die Durchschlagspannung zwischen den Elektroden (3a, 3b) durch ein einwandfreies Prüfobjekt (2) ohne Löcher oder Risse ist und
- Feststellen ob Löcher oder Risse in dem Prüfobjekt (2) vorliegen durch Erkennen eines Durchschlags zwischen den Elektroden (3a, 3b).

2. Verfahren nach Anspruch 1, **dadurch gekennzeichnet, dass** jedes Prüfobjekt (2) entlang der Transportstrecke zwischen der oberen Elektrode (3a) und der unteren Elektrode (3b) transportiert wird, ohne diese zu berühren.

3. Verfahren nach Anspruch 1 oder 2, **dadurch gekennzeichnet, dass** der Abstand zwischen der oberen und unteren Elektrode (3a, 3b) in Anhängigkeit von der größten Erstreckung der Prüfobjekte (2) senkrecht zu der Transportebene (4) eingestellt wird.

4. Verfahren nach einem der Ansprüche 1 bis 3, **dadurch gekennzeichnet, dass** die erste Spannungsquelle (5) eine zeitlich veränderliche Spannung erzeugt.

5. Verfahren nach Anspruch 4, **dadurch gekennzeichnet, dass** die erste Spannungsquelle (5) einen Transformator mit einer Sekundärseite und einer Primärseite umfasst, wobei die Steuerung der ersten Spannungsquelle über ein Ein - und Ausschalten einer an der Primarseite anliegenden Eingangsspannung erfolgt.

6. Verfahren nach einem der Ansprüche 1 bis 5, **dadurch gekennzeichnet, dass** die zweite Spannungsquelle (6) eine zeitlich konstante Spannung erzeugt.

7. Verfahren nach einem der Ansprüche 1 bis 6, **dadurch gekennzeichnet, dass** die erste und zweite Spannungsquelle (5,6) durch Anschluss an einen gemeinsamen Massepunkt (7) elektrisch in Reihe geschaltet werden.

8. Verfahren nach einem der Ansprüche 1 bis 6, **dadurch gekennzeichnet, dass** die bereitgestellte Elektrodenanordnung (3) miteinander fluchtende, stabförmige Elektroden (3a, 3b) aufweist.

9. Verfahren nach Anspruch 8, **dadurch gekennzeichnet, dass** bei der Prüfung von Prüfobjekten (2) mit einer einen Mittelpunkt aufweisenden Bodenfläche (2a) die erste Spannungsquelle (5) derart gesteuert wird, dass eine Spannung von der ersten Spannungsquelle (5) erzeugt wird, wenn sich der Mittelpunkt in der Flucht oder in einem festgelegten Bereich um die Flucht herum befindet, wobei der festgelegte Bereich kleiner als die Bodenfläche ist.

10. Verfahren nach einem der Ansprüche 1 bis 9, **dadurch gekennzeichnet, dass** die Position jedes Prüfobjekts (2) auf der Transportstrecke mit Hilfe von Sensoren erfasst wird.

11. Verfahren nach einem der Ansprüche 1 bis 10, **dadurch gekennzeichnet, dass** die Höhe der von der ersten Spannungsquelle (5) erzeugten Spannung maximal 50% der Höhe der von der zweiten Spannungsquelle (6) erzeugten Spannung beträgt.

12. Verfahren nach einem der Ansprüche 1 bis 11, **dadurch gekennzeichnet, dass** ein Durchschlag erkannt wird, wenn ein Strom zwischen der oberen und unteren Elektrode (3a, 3b) fließt.

13. Verfahren nach einem der Ansprüche 1 bis 11, **dadurch gekennzeichnet, dass** ein Durchschlag erkannt wird, wenn die Höhe der von der zweiten Spannungsquelle (6) erzeugten Spannung zeitweilig abnimmt.

14. Verfahren nach einem der Ansprüche 1 bis 13, **dadurch gekennzeichnet, dass** Verlauf der Entladungsstrecke (3c) durch gezielte Ionisierung der Luft beeinflusst wird.

15. Verfahren nach einem der Ansprüche 1 bis 14, **dadurch gekennzeichnet, dass** Verlauf der Entladungsstrecke (3c) durch mindestens ein magnetisches Feld beeinflusst wird.

16. Verfahren einem der Ansprüche 1 bis 15, **dadurch gekennzeichnet, dass** eine Prüfung von aus Kunststoff spritzgegossenen Prüfobjekten (2) erfolgt.

17. Verfahren nach Anspruch 16, **dadurch gekennzeichnet, dass** die Prüfobjekte (2) während des Transports entlang der Prüfstrecke zusätzlich eine optische Prüfeinrichtung durchlaufen, die zum Lesen von in die Prüfobjekte eingegossenen Informationen eingerichtet ist.

18. Vorrichtung (1) zur Prüfung von übereinstimmenden Prüfobjekten (2) auf das Vorliegen von Löchern oder Rissen in einer Bodenfläche (2a), wobei jedes Prüfobjekt von der Bodenfläche (2a), einer der Bodenfläche gegenüberliegenden Öffnung (2b) und einer sich zwischen der Öffnung und der Bodenfläche erstreckenden Mantelfläche (2c) begrenzt wird, umfassend
- eine Elektrodenanordnung (3) mit einer oberhalb einer Transportebene (4) ortsfest angeordneten oberen Elektrode (3a) und eine unterhalb der Transportebene (4) ortsfest angeordneten unteren Elektrode (3b) sowie einer Entladungsstrecke (3c) zwischen der oberen und unteren Elektrode,
- eine erste, gesteuerte Spannungsquelle (5), die mit einer der beiden Elektroden (3a) verbunden ist und eine zweite Spannungsquelle (6), die mit der anderen der beiden Elektroden (3b) verbunden ist, wobei die beiden Spannungsquellen (5, 6) elektrisch in Reihe geschaltet sind,
- eine Transporteinrichtung eingerichtet zum Transportieren jedes Prüfobjektes entlang einer in der Transportebene (4) liegenden Transportstrecke, die zwischen der oberen und der unteren Elektrode (3a, 3b) verläuft,
- eine Steuerung (9), die die erste Spannungsquelle (5) und die zweite Spannungsquelle (6) derart steuert, dass
- eine Spannung von der ersten Spannungsquelle (5) nur dann erzeugt wird, wenn sich eines der Prüfobjekte (2) zwischen der oberen und unteren Elektrode (3a, 3b) befindet,
- eine Spannung von der zweiten Spannungsquelle (6) kontinuierlich während der Prüfung von Prüfobjekten (2) erzeugt wird, wobei die Summe der von beiden Spannungsquellen (5, 6) erzeugten Spannungen als Prüfspannung (10) zwischen den Elektroden (3a, 3b) anliegt,
- die Höhe der Prüfspannung (10) größer oder gleich der Durchschlagspannung zwischen den Elektroden (3a, 3b) in Luft und kleiner als die Durchschlagspannung durch ein einwandfreies Prüfobjekt (2) ohne Löcher oder Risse zwischen den Elektroden ist
und
- eine Auswerteeinrichtung (8) eingerichet zum Erkennen eines Durchschlags auf der Entladungsstrecke (3c) zwischen den Elektroden (3a, 3b).

19. Vorrichtung nach Anspruch 18, **dadurch gekennzeichnet, dass** der Abstand zwischen der oberen und unteren Elektrode (3a, 3b) einstellbar ist.

20. Vorrichtung nach einem der Ansprüche 18 oder 19, **dadurch gekennzeichnet, dass** die erste Spannungsquelle (5) zur Erzeugung einer zeitlich veränderlichen Spannung eingerichtet ist.

21. Vorrichtung nach Anspruch 20, **dadurch gekennzeichnet, dass** die erste Spannungsquelle (5) einen Transformator mit einer Sekundärseite und einer Primärseite aufweist, wobei an der Primärseite zeitweilig eine von der Steuerung (9) gesteuerte Eingangsspannung anliegt, wobei das Verhältnis der sekundärseitig erzeugten Spannung zur Eingangsspannung größer als 100 : 1 ist.

22. Vorrichtung nach einem der Ansprüche 18 bis 21, **dadurch gekennzeichnet, dass** die zweite Spannungsquelle (6) eine Gleichspannungsquelle ist.

23. Vorrichtung nach einem der Ansprüche 18 bis 22, **dadurch gekennzeichnet, dass** die Elektrodenanordnung (3) miteinander fluchtende, stabförmige Elektroden (3a, 3b) aufweist.

24. Vorrichtung nach einem der Ansprüche 18 bis 22, **dadurch gekennzeichnet, dass** die Vorrichtung (1) mindestens einen mit der Steuerung verbundenen Sensor aufweist, der zum Erfassen der Position eines der Prüfobjekte auf der Transportstrecke zwischen den Elektroden eingerichtet ist.

25. Vorrichtung nach einem der Ansprüche 18 bis 24, **dadurch gekennzeichnet, dass** die Auswerteeinrichtung (8) eine Strommesseinrichtung zum Messen eines Stromflusses zwischen der oberen und unteren Elektrode (3a, 3b) aufweist.

26. Vorrichtung nach einem der Ansprüche 18 bis 25, **dadurch gekennzeichnet, dass** die Auswerteeinrichtung (8) eine Spannungsmesseinrichtung zum Messen der Höhe der von der zweiten Spannungsquelle (6) erzeugten Spannung aufweist.

27. Vorrichtung nach einem der Ansprüche 18 bis 26, **dadurch gekennzeichnet, dass** die Vorrichtung (1) mindestens eine zur Ionisierung von Luft geeignete Strahlungsquelle (11) aufweist, und die Strahlungsquelle (11) derart angeordnet ist, dass die Luft entlang der Entladungsstrecke (3c) ionisiert wird.

28. Vorrichtung nach einem der Ansprüche 18 bis 27, **dadurch gekennzeichnet, dass** die Vorrichtung (1) mindestens einen benachbart zu der Entladungsstrecke angeordneten Magnet aufweist, wobei die Feldlinien des magnetische Feldes parallel zu der Entladungsstrecke (3c) verlaufen.

29. Vorrichtung nach einem der Ansprüche 18 bis 28, **dadurch gekennzeichnet, dass** entlang der Transportstrecke zusätzlich eine optische Prüfeinrichtung angeordnet ist, die zum Lesen von in die Prüfobjekte (2) eingegossenen Informationen eingerichtet ist.

## Claims

1. A method for testing consistent test objects (2) for the presence of holes or cracks in a bottom surface (2a), wherein each test object (2) is delimited by the bottom surface (2a), an opening (2b) situated opposite the bottom surface (2a) and a lateral surface (2c) extending between the opening (2b) and the bottom surface (2a), comprising the steps:
- providing an electrode arrangement (3) comprising an upper electrode (3a) arranged in a fixed position above a transport plane (4) and a lower electrode (3b) arranged in a fixed position beneath the transport plane (4), as well as a discharge path (3c) between the upper and the lower electrode,
- connecting a first controlled voltage source (5) to one of the two electrodes (3a) and connecting a second voltage source (6) to the other of the two electrodes (3b), wherein the two voltage sources (5, 6) are connected electrically in series,
- transporting each of the test objects (2) along a transport path lying in the transport plane (4), which runs between the upper electrode (3a) and the lower electrode (3b),
- controlling the first and second voltage source (5, 6) in such a manner that a voltage of the first voltage source (5) is generated only when one of the test objects (2) is located between the upper and the lower electrode (3a, 3b), and a voltage of the second voltage source (6) is generated continuously during the testing of the test objects (2), wherein the sum of the voltages generated by the two voltage sources (5, 6) is applied as a test voltage (10) to the electrodes (3a, 3b),
- controlling the magnitude of the test voltage (10) in such a manner that it is greater than or equal to the breakdown voltage between the electrodes (3a, 3b) in air and smaller than the breakdown voltage between the electrodes (3a, 3b) through a flawless test object (2) without holes or cracks, and
- determining whether holes or cracks are present in the test object (2)by detecting a breakdown between the electrodes (3a, 3b).

2. The method according to claim 1, **characterized in that** each test object (2) is transported along the transport path between the upper electrode(3a) and the lower electrode (3b) without touching these.

3. The method according to claim 1 or 2, **characterized in that** the distance between the upper and lower electrode (3a, 3b) is adjusted as a function of the greatest extension of the test objects (2) perpendicular to the transport plane (4).

4. The method according toone of claims 1 to 3, **characterized in that** the first voltage source (5) generates a time-variable voltage.

5. The method according to claim 4, **characterized in that** the first voltage source (5) comprises a transformer with a secondary side and a primary side, wherein the control of the first voltage source is made by switching on and off an input voltage applied at the primary side.

6. The method according toone of claims 1 to 5, **characterized in that** the second voltage source (6) generates a time-constant voltage.

7. The method according toone of claims 1 to 6, **characterized in that** the first and second voltage source (5, 6) are connected electrically in series by connection to a common ground point (7).

8. The method according toone of claims 1 to 6, **characterized in that** the provided electrode arrangement (3) comprises rod-shaped electrodes (3a, 3b) which are aligned with each other.

9. The method according to claim 8, characterized in thatduring the testing of test objects (2) with a bottom surface(2a) having a centre point, the first voltage source (5) is controlled in such a manner that a voltage of the first voltage source (5) is generated when the centre point is in alignment or in a specified region around the alignment, wherein the specified region is smaller than the bottom surface.

10. The method according to one of claims 1 to 9, **characterized in that** the position of each test object (2) on the transport path is detected by sensors.

11. The method according to one of claims 1 to 10, **characterized in that** the magnitude of the voltage generated by the first voltage source (5) is at most 50% of the magnitude of the voltage generated by the second voltage source (6).

12. The method according to one of claims 1 to 11, **characterized in that** a breakdown is identified when a current flows between the upper and lower electrode (3a, 3b).

13. The method according to one of claims 1 to 11, **characterized in that** a breakdown is identified when the magnitude of the voltage generated by the second voltage source (6) decreases temporarily.

14. The method according to one of claims 1 to 13, **characterized in that** the course of the discharge path (3c) is influenced by specific ionization of the air.

15. The method according to one of claims 1 to 14, **characterized in that** the course of the discharge path (3c) is influenced by at least one magnetic field.

16. The method according to one of claims 1 to 15, **characterized in that** injection-moulded test objects (2) made of plastic are tested.

17. The method according to claim 16, **characterized in that** during the transport along the test path the test objects (2) additionally run through an optical testing device which is adapted to read information moulded into the test objects.

18. A device (1) for testing consistent test objects (2) for the presence of holes or cracks in a bottom surface (2a), wherein each test object is delimited by the bottom surface (2a), an opening (2b) situated opposite the bottom surface and a lateral surface (2c) extending between the opening and the bottom surface, comprising:
- an electrode arrangement (3) with an upper electrode (3a) arranged in a fixed position above a transport plane (4) and a lower electrode (3b) arranged in a fixed position beneath the transport plane (4), as well as a discharge path (3c) between the upper and lower electrode,
- a first controlled voltage source (5) connected to one of the two electrodes (3a) and a second voltage source (6) connected to the other of the two electrodes (3b), wherein the two voltage sources (5, 6) are connected electrically in series,
- a transport device adapted to transport each test object along a transport path lying in the transport plane (4), which runs between the upper and the lower electrode (3a, 3b),
- a control system (9) which controls the first voltage source (5) and the second voltage source (6) in such a manner that
- a voltage of the first voltage source (5) is generated only when one of the test objects (2) is located between the upper and the lower electrode (3a, 3b),
- a voltage of the second voltage source (6) is generated continuously during the testing of the test objects (2), wherein the sum of the voltages generated by the two voltage sources (5, 6) is applied as a test voltage (10) between the electrodes (3a, 3b),
- the magnitude of the test voltage (10) is greater than or equal to the breakdown voltage between the electrodes (3a, 3b) in air and smaller than the breakdown voltage through a flawless test object (2) without holes or cracks between the electrodes,
and
- an evaluation device (8) adapted to identify a breakdown on the discharge path (3c) between the electrodes (3a, 3b).

19. The device according to claim 18, **characterized in that** the distance between the upper and lower electrode (3a, 3b) is adjustable.

20. The device according to one of claims 18 or 19, **characterized in that** the first voltage source (5) is adapted to generate a time-variable voltage.

21. The device according to claim 20, **characterized in that** the first voltage source (5) comprises a transformer with a secondary side and a primary side, wherein an input voltage controlled by the control system (9) is temporarily applied to the primary side, wherein the ratio between the voltage generated on the secondary side to the input voltage is greater than 100:1.

22. The device according to one of claims 18 to 21, **characterized in that** the second voltage source (6) is a DC voltage source.

23. The device according to one of claims 18 to 22, **characterized in that** the electrode arrangement (3) comprises rod-shaped electrodes (3a, 3b)which are aligned with each other.

24. The device according to one of claims 18 to 22, **characterized in that** the device (1) comprises at least one sensor connected to the control system which is adapted to detect the position of one of the test objects on the transport path between the electrodes.

25. The device according to one of claims 18 to 24, **characterized in that** the evaluation device (8)comprises a current measuring device to measure a flow of current between the upper and lower electrode (3a, 3b).

26. The device according to one of claims 18 to 25, **characterized in that** the evaluation device (8) comprises a voltage measuring device to measure the magnitude of the voltage generated by the second voltage source (6).

27. The device according to one of claims 18 to 26, **characterized in that** the device (1) comprises at least one radiation source (11) suitable for ionization of air, and the radiation source (11) is arranged in such a manner that the air is ionized along the discharge path (3c).

28. The device according to one of claims 18 to 27, **characterized in that** the device (1) comprises at least one magnet arranged adjacent to the discharge path, wherein the field lines of the magnetic field run parallel to the discharge path (3c).

29. The device according to one of claims 18 to 28, **characterized in that** an optical testing device is additionally arranged along the transport path, which is adapted to read information moulded into the test objects (2).

## Revendications

1. Procédé, destiné à examiner des objets d'essai (2) concordants pour détecter la présence de trous ou de fissures dans unesurface de fond inférieur (2a), chaqueobjet d'essai (2) étant délimité par lasurface de fond inférieur (2a), par un orifice (2b) situé au vis-à-vis de la surface de fond inférieur (2a) et par une surface d'enveloppe (2c) s'étendant entre l'orifice (2b) et lasurface de fond inférieur (2a), comprenant les étapes, consistant à :
- mettre à disposition unagencement d'électrodes (3) comprenant uneélectrode supérieure (3a) placée de manière stationnaire au-dessus d'un plan de transport (4) et une électrode inférieure (3b) placée de manière stationnaire en-dessous du plan de transport (4), ainsi qu'un trajet de décharge (3c) entre l'électrode supérieure et l'électrode inférieure,
- connecter une premièresource de tension(5) commandée avec l'une des deux électrodes (3a) et connecter une deuxième source de tension (6) avec l'autre des deuxélectrodes (3b), les deuxsources de tension (5, 6) étant électriquement montées en série,
- transporter chaqueobjet d'essai (2) le long d'untrajet de transport situé dans le plan de transport (4), qui s'écoule entre l'électrode supérieure (3a) et l'électrode inférieure (3b),
- commander la première et la deuxièmesources de tension (5, 6) de sorte qu'une tension ne soit générée par lapremièresource de tension (5) que si l'un des objets d'essai (2) se trouve entre l'électrode supérieure et l'électrode inférieure (3a, 3b) et qu'une tension soit générée en continu par la deuxièmesource de tension (6) pendant l'examen de l'objet de test (2), la somme des tensions générées par lesdeuxsources de tension (5, 6) étant appliquée en tant quetension d'essai (10) sur lesélectrodes (3a, 3b),
- commander le niveau de latension d'essai (10) de sorte qu'elle soit supérieure ou égale à la tension de claquageentre lesélectrodes (3a, 3b) dans l'air et inférieure à latension de claquageentre lesélectrodes (3a, 3b) à travers un objet d'essai (2) impeccable, sans trous ni fissures et
- constater la présence de trous ou de fissures dans l'objet d'essai (2) par identification d'unclaquageentre lesélectrodes (3a, 3b).

2. Procédé selon la revendication 1, **caractérisé en ce que** chaque objet d'essai (2) est transporté le long du trajet de transport entre l'électrode supérieure (3a) et l'électrode inférieure (3b) sans contact avec celui-ci.

3. Procédé selon la revendication 1 ou 2,**caractérisé en ce qu'**onrègle l'écart entre l'électrode supérieure et l'électrode inférieure (3a, 3b) en fonction de la plus grande extension des objets d'essai (2) à la perpendiculaire du plan de transport (4).

4. Procédé selon l'une quelconque des revendications 1 à 3, **caractérisé en ce que** la première source de tension (5) génère une tension variable dans le temps.

5. Procédé selon la revendication 4, **caractérisé en ce que** la première source de tension (5) comprend un transformateur pourvu d'un côté secondaire et d'un côté primaire, la commande de la première source de tension s'effectuant par une mise en marche et à l'arrêt d'une tension d'entrée appliquée sur le côté primaire.

6. Procédé selon l'une quelconque des revendications 1 à 5, **caractérisé en ce que** la deuxième source de tension (6) génère une tension constante dans le temps.

7. Procédé selon l'une quelconque des revendications 1 à 6, **caractérisé en ce qu'**on monte électriquement en série la première et la deuxième sources de tension (5,6) par raccordement sur unpoint de masse (7)commun.

8. Procédé selon l'une quelconque des revendications 1 à 6, **caractérisé en ce que** l'agencement d'électrodes (3) mis à disposition comporte des électrodes (3a, 3b) en forme de tiges, alignées les unes sur les autres.

9. Procédé selon la revendication 8, **caractérisé en ce que** lors de l'examen d'objets de test (2) pourvus d'unesurface de fond inférieur (2a) comportant un point médian, on commande la premièresource de tension (5) de telle sorte qu'une tension soit générée par la premièresource de tension (5) lorsque le point médian se trouve en alignement ou dans une plage définie autour de l'alignement, la plage définie étant inférieure à la surface de fond inférieur.

10. Procédé selon l'une quelconque des revendications 1 à 9, caractérisé en ce quela position de chaqueobjet d'essai (2) sur letrajet de transportest détectée à l'aide de capteurs.

11. Procédé selon l'une quelconque des revendications 1 à 10, **caractérisé en ce que** le niveau de la tension générée par la premièresource de tension (5) s'élève au maximum à 50% du niveau de la tension générée par la deuxièmesource de tension (6).

12. Procédé selon l'une quelconque des revendications 1 à 11, **caractérisé en ce qu'**un claquage est détecté lorsqu'un courant circule entre l'électrode supérieure et l'électrode inférieure (3a, 3b).

13. Procédé selon l'une quelconque des revendications 1 à 11,**caractérisé en ce qu'**unclaquageest détecté lorsque le niveau de la tension générée par ladeuxièmesource de tension (6) décroît temporairement.

14. Procédé selon l'une quelconque des revendications 1 à 13, **caractérisé en ce que** la courbe dutrajet de décharge (3c) est influencée par une ionisation ciblée de l'air.

15. Procédé selon l'une quelconque des revendications 1 à 14, **caractérisé en ce que** la courbe dutrajet de décharge (3c) est influencée par au moins un champ magnétique.

16. Procédé selon l'une quelconque des revendications 1 à 15, **caractérisé en ce qu'**il est procédé à un examen d'objets de test (2) injectés sur de la matière plastique.

17. Procédé selon la revendication 16, **caractérisé en ce que** pendant le transport, le long du trajet d'essai, les objets d'essai (2) traversent en supplément un système d'essai optique qui est aménagé pour lire des informations moulées dans les objetsd'essai.

18. Dispositif (1) destiné à examiner des objets d'essai (2) concordants pour détecter la présence de trous ou de fissures dans une surface de fond inférieur (2a), chaque objet d'essai étant délimité par la surface de fond inférieur (2a), par un orifice (2b) situé au vis-à-vis de la surface de fond inférieur et par une surface d'enveloppe (2c) s'étendant entre l'orifice (2b) et la surface de fond inférieur (2a),comprenant
- unagencement d'électrodes (3), doté d'uneélectrode supérieure (3a) placée de manière stationnaire au-dessus d'un plan de transport (4) et d'une électrode inférieure (3b) placée de manière stationnaire en-dessous du plan de transport (4), ainsi que d'un trajet de décharge (3c) entre l'électrode supérieure et l'électrode inférieure,
- une première source de tension (5) commandée qui est connectée avec l'une des deux électrodes (3a) et une deuxième source de tension (6) qui est connectée avec l'autre des deux électrodes (3b), les deux sources de tension (5, 6) étant électriquement montées en série,
- un système de transport aménagé pour transporter chaqueobjet d'essai le long d'un trajet de transport situé le long duplan de transport (4) qui s'écoule entre l'électrode supérieure etl'électrode inférieure (3a, 3b),
- unsystème de commande (9), qui commande la première source de tension (5) et la deuxième source de tension (6) de telle sorte
- qu'une tension ne soit générée par la premièresource de tension (5) que lorsque l'un desobjets d'essais (2) se trouve entre l'électrode supérieure etl'électrode inférieure (3a, 3b),
- que pendant l'examen d'objets de test (2), une tension soit générée en continu par ladeuxièmesource de tension (6), la somme des tensions générées par les deux sources de tension (5, 6) étant appliquée en tant quetension d'essai (10) entre lesélectrodes (3a, 3b),
- que le niveau de latension d'essai (10) soit supérieur ou égal à latension de claquageentre lesélectrodes (3a, 3b) dans l'air et inférieur à latension de claquageà travers unobjet d'essai (2) impeccable, sans trous ni fissuresentre lesélectrodes
et
- une unité d'évaluation (8), aménagée pour détecter un claquagesur letrajet de décharge (3c) entre lesélectrodes (3a, 3b).

19. Dispositif selon la revendication 18,**caractérisé en ce que** l'écart entrel'électrode supérieureet l'électrode inférieure (3a, 3b) est réglable.

20. Dispositif selon l'une quelconque des revendications 18 ou 19,**caractérisé en ce que** la première source de tension (5) est aménagée pour générer une tension variable dans le temps.

21. Dispositif selon la revendication 20, **caractérisé en ce que** la première source de tension (5) comporte un transformateur doté d'un côté secondaire et d'un côté primaire,sur le côté primaire étant appliquée temporairement une tension d'entrée commandée par lesystème de commande (9), le rapport entre la tension générée par le côté secondaire et la tension d'entrée étant supérieur à 100 : 1.

22. Dispositif selon l'une quelconque des revendications 18 à 21, **caractérisé en ce que** la deuxième source de tension (6) est une source de tension continue.

23. Dispositif selon l'une quelconque des revendications 18 à 22, **caractérisé en ce que** l'agencement d'électrodes (3) comporte desélectrodes (3a, 3b) en forme de tiges, alignées les unes sur les autres.

24. Dispositif selon l'une quelconque des revendications 18 à 22, **caractérisé en ce que** le dispositif (1) comporte au moins un capteur connecté sur lesystème de commandequi est aménagé pour détecter la position de l'un desobjets d'essai sur letrajet de transportentre lesélectrodes.

25. Dispositif selon l'une quelconque des revendications 18 à 24, **caractérisé en ce que** le système d'évaluation (8) comporte un système ampèremétrique, destiné à mesurer uncourant circulant entrel'électrode supérieureet l'électrode inférieure (3a, 3b).

26. Dispositif selon l'une quelconque des revendications 18 à 25, **caractérisé en ce que** le système d'évaluation (8) comporte un dispositif de mesure de tension, destiné à mesurer le niveau de tension généré par la deuxièmesource de tension (6).

27. Dispositif selon l'une quelconque des revendications 18 à 26, **caractérisé en ce que** le dispositif (1) comporte au moins une source de rayonnement (11) apte à l'ionisation d'air et **en ce que** la source de rayonnement (11) est placée de telle sorte que l'air soit ionisé le long dutrajet de décharge (3c).

28. Dispositif selon l'une quelconque des revendications 18 à 27, **caractérisé en ce que** le dispositif (1) comporte au moins un aimant placé au voisinage dutrajet de décharge, les lignes de champ du champ magnétique s'écoulant à la parallèle dutrajet de décharge (3c).

29. Dispositif selon l'une quelconque des revendications 18 à 28, **caractérisé en ce que** le long dutrajet de transportest placé en supplément un système d'essai optique, qui est aménagé pour lire des informations coulées dans les objets d'essai (2).
